# EUROPEAN PATENT APPLICATION

(11) **EP 4 733 892 A1**
(43) Date of publication of application: **29.04.2026**
(21) Application number: 25156755.8
(22) Date of filing: 10.02.2025
(51) Int. Cl.: G06F 1/18, G06F 1/20, H05K 7/20

(54) **COMPUTER CHASSIS STRUCTURE AND COMPUTER HOST**

(30) Priority: 24.10.2024 TW 113211541 U; 12.12.2024 TW 113213688 U
(71) Applicant: Akasa Asia Corp., New Taipei City 241 (TW)
(72) Inventor: CHEN, YI-TSEN, 242622 New Taipei City (TW)
(74) Representative: Rapisardi, Mariacristina

(57) **Abstract**

A computer chassis structure (100) includes: a box body (1) comprising a bottom plate (11) and a plurality of side walls (12); a backplate (2); a pre-pressure assembly (3); and a CPU holder (4). The backplate (2) has an outer face (21) and an inner face (22) opposite to the outer face, and the inner face (22) is disposed towards the bottom plate (11). The backplate (2), the bottom plate (11) and the plurality of side walls (12) are sandwiched to form an accommodation space (S). The pre-pressure assembly (3) is disposed in the accommodation space (S), the pre-pressure assembly (3) includes a pushing piece (31) and a pressure-receiving piece (32). The pressure-receiving piece (32) is disposed at the bottom plate (11), and the pushing piece (31) pushes an adjustable pre-pressure toward the pressure-receiving piece (32). The CPU holder (4) is fixedly connected to the pressure-receiving piece (32). A computer host (200) includes: a motherboard (P) and the computer chassis structure (100) as described above.

## Description

### BACKGROUND OF THE INVENTION

### 1. Field of the Invention

The present disclosure relates to a computer chassis and a computer host, and in particular to a computer chassis structure and a computer host that can enhance heat dissipation.

### 2. Description of the Related Art

Fanless computer chassis have many benefits, including reducing openings to prevent dust accumulation, and also reducing the size of the computer chassis. However, the primary problem faced by fanless computer chassis is how to effectively dissipate heat from the high temperature areas on the motherboard, especially the central processing unit (CPU). In addition, since the position of the CPU on the motherboard of each product model is slightly different, how to design a computer chassis that can be widely used for each motherboard is also a problem to be solved.

### BRIEF SUMMARY OF THE INVENTION

Therefore, in order to solve the problems of the traditional computer chassis, the present disclosure proposes a computer chassis structure that can enhance heat dissipation.

To achieve the above objective and other objectives, the present disclosure proposes a computer chassis structure, which includes: a box body comprising a bottom plate and a plurality of side walls surrounding the bottom plate; a backplate, having an outer face and an inner face opposite to the outer face, wherein the inner face is disposed towards the bottom plate and the backplate, the bottom plate and the plurality of side walls are sandwiched to form an accommodation space; a pre-pressure assembly, disposed in the accommodation space, wherein the pre-pressure assembly includes a pushing piece and a pressure-receiving piece, the pressure-receiving piece is disposed at the bottom plate, and the pushing piece pushes an adjustable pre-pressure toward the pressure-receiving piece along a covering direction of the backplate; and a CPU holder, fixedly connected to the pressure-receiving piece.

In one embodiment of the disclosure, one end of the pushing piece is connected to the inner face to push the adjustable pre-pressure toward the pressure-receiving piece.

In one embodiment of the disclosure, one end of the pushing piece is indirectly connected to the box body to push the adjustable pre-pressure toward the pressure-receiving piece.

In one embodiment of the disclosure, the pre-pressure assembly further includes a pre-pressure plate, which is disposed in the accommodation space, and one end of the pushing piece is indirectly connected to the box body through the pre-pressure plate.

In one embodiment of the disclosure, the pre-pressure plate is connected to at least two of the plurality of side walls.

In one embodiment of the disclosure, the pre-pressure plate is connected to the bottom plate.

In one embodiment of the disclosure, the pre-pressure assembly includes a plurality of pushing pieces and a plurality of pressure-receiving pieces, and the plurality of pressure-receiving pieces surround the CPU holder.

In one embodiment of the disclosure, the pre-pressure assembly further includes a screw to fixedly connect the pressure-receiving piece and a motherboard.

In one embodiment of the disclosure, an outer surface of the box body is provided with a plurality of heat dissipation fins.

The disclosure further proposes a computer host, including: a motherboard; and the computer chassis structure as described above, wherein the pushing piece passes through the motherboard and pushes the pressure-receiving piece.

Accordingly, the computer chassis structure and the computer host of the present disclosure can force the CPU holder to be closely connected to the bottom plate of the box body, so that the CPU can form thermal contact with the bottom plate of the box body through the pre-pressure from the pre-pressure assembly, and the heat is dissipated through the bottom plate of the box body, improving the heat dissipation efficiency of the CPU or other high temperature areas. In addition, it can also allow various types and sizes of motherboards to be used in the same size and specification of computer chassis, without the need to design special computer chassis for different motherboards.

### BRIEF DESCRIPTION OF THE DRAWINGS

FIG. 1 is a schematic perspective view of a computer chassis structure according to the first embodiment of the present disclosure.
FIG. 2 is an exploded view of a computer host according to the first embodiment of the present disclosure.
FIG. 3 is a schematic cross-sectional view of a computer chassis structure according to the second embodiment of the present disclosure.
FIG. 4 is a schematic cross-sectional view of a computer chassis structure according to the third embodiment of the present disclosure.

### DETAILED DESCRIPTION OF THE INVENTION

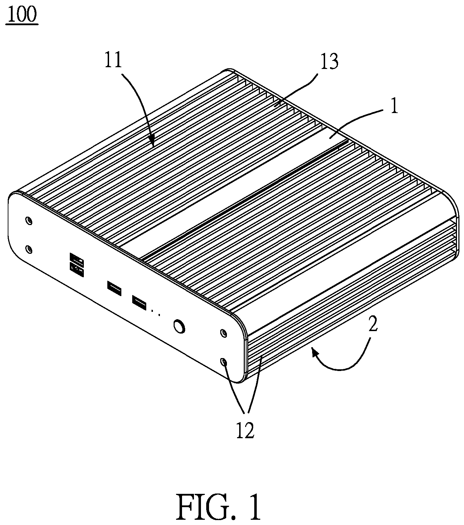

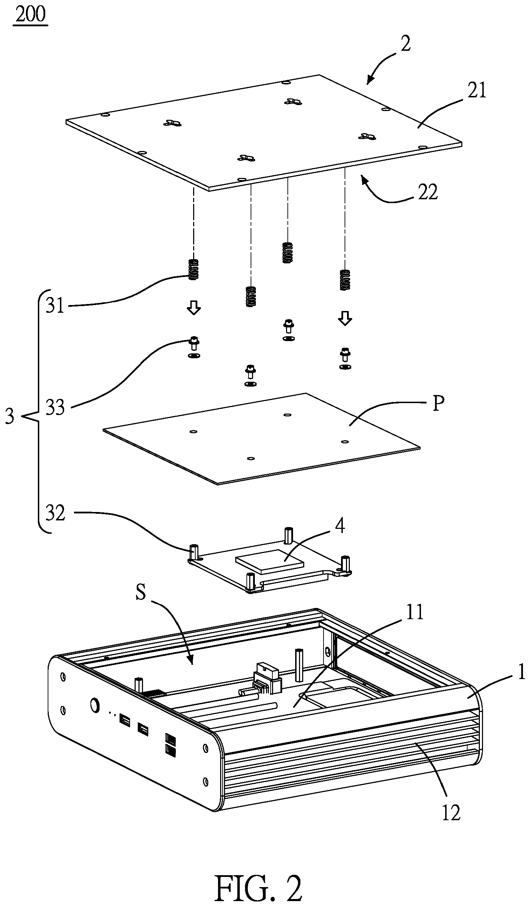

To facilitate understanding of the present disclosure, the following specific embodiments together with the attached drawings for the detailed description of the present application are provided. One skilled in the art can understand the object, characteristics and effects of this present disclosure by the content described in the specification. It should be noted that various possible modifications and alterations to the details of the specification could be carried out by implementing or applying other different embodiments based on different views and applications without departing from the spirit of the present application. The related technical contents of the application will be described in detail by the embodiments. However, the disclosed contents should not be considered to limit the scope of the application. The description is provided as follows:
As shown in FIGS. 1 and 2, a computer chassis structure 100 in a first embodiment of the present disclosure includes: a box body 1, a backplate 2, a pre-pressure assembly 3 and a CPU holder 4.

The box body 1 is mainly made of metallic material that is robust and thermally conductive, and includes a bottom plate 11 and a plurality of side walls 12 surrounding the bottom plate 11. The box body 1 has an opening for the backplate 2 setting.

The backplate 2 has an outer face 21 and an inner face 22 opposite to the outer face 21, and the inner face 22 is disposed towards the bottom plate 11, and the backplate 2, the bottom plate 11 and the plurality of side walls 12 are sandwiched to form an accommodation space S. The backplate 2 is also mainly made of robust material, such as metal.

The pre-pressure assembly 3 is disposed in the accommodation space S, the pre-pressure assembly 3 includes a pushing piece 31 and a pressure-receiving piece 32. The pressure-receiving piece 32 is disposed at the bottom plate 11, and the pushing piece 31 pushes an adjustable pre-pressure toward the pressure-receiving piece 32 along a covering direction of the backplate 2 (as shown in FIG.2). In the embodiment, the pushing piece 31, for example, is a spring, which can push the pressure-receiving piece 32 after being compressed. However, the present disclosure is not limited thereto, and the pushing piece 31 may also be of other structures, such as an elastic column made of an elastic body. The top of the pressure-receiving piece 32 is in contact with the pushing member 31 and receives the pre-pressure from the pushing piece 31.

The CPU holder 4 is used for connecting and bearing a CPU on a motherboard P. The CPU holder 4 and the CPU may be fixed through heat dissipation glue or other means to form heat conduction. The CPU holder 4 is fixedly connected to the pressure-receiving piece 32. When the pressure-receiving piece 32 receives the pre-pressure from the pushing piece 31, the CPU holder 4 is forced to be closely connected to the box body 1, so that the CPU can form thermal contact with the box body 1 through the pre-pressure from the pre-pressure assembly 3, and the heat is dissipated through the box body 1 and/or bottom plate 11. In this way, the heat dissipation efficiency of the CPU or other high temperature areas can be improved in comparison to traditional computer chassis. In addition, regardless of the specifications and size of the CPU position of the various types of motherboard products produced by various manufacturers, as long as the CPU thereon is connected to the CPU holder 4, the pre-pressure assembly 3 can be used to cause the CPU and the box body 1 to form thermal contact, so it can be widely used in the computer chassis of the same size and specification, and there is no need to design special computer chassis for different motherboards.

In the present embodiment, one end of the pushing piece 31 is connected to the inner face 22 to push the adjustable pre-pressure toward the pressure-receiving piece 32. The pre-pressure is decided by a downward stroke of the backplate 2. By adjusting the pre-pressure stroke of the backplate 2, the pre-pressure exerted on the pressure-receiving piece 32 and the CPU holder 4 can be changed.

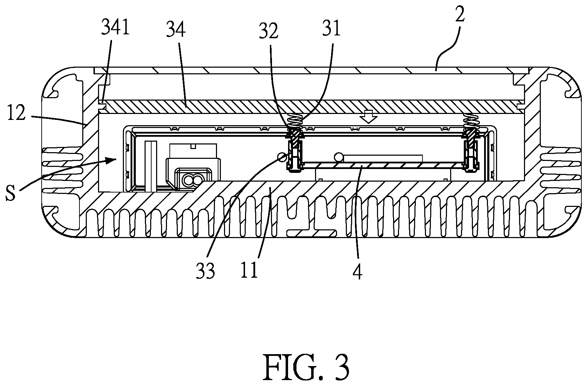

However, the present invention is not limited to the above embodiments. In other embodiments, the backplate 2 is not the final component that presses down the pushing piece 31 and the pressure-receiving piece 32. Instead, one end of the pushing piece 31 is indirectly connected to the box body 1 to push the adjustable pre-pressure toward the pressure-receiving piece 32. For example, as shown in FIG. 3, in the second embodiment of the present invention, the pre-pressure assembly 3 further includes a pre-pressure plate 34, which is disposed in the accommodation space S. One end of the pushing piece 31 is indirectly connected to the box body 1 through the pre-pressure plate 34 . Specifically, in this embodiment, the pre-pressure plate 34 is engaged with at least two side walls 12 by tenon portions 341, and the side walls 12 have corresponding engaging structures. The engagement height of the pre-pressure plate 34 and the side wall 12 determines the pre-pressure stroke. By adjusting the pre-pressure stroke of the pre-pressure plate 34, the pre-pressure exerted on the pressure-receiving piece 32 and the CPU holder 4 can be changed.

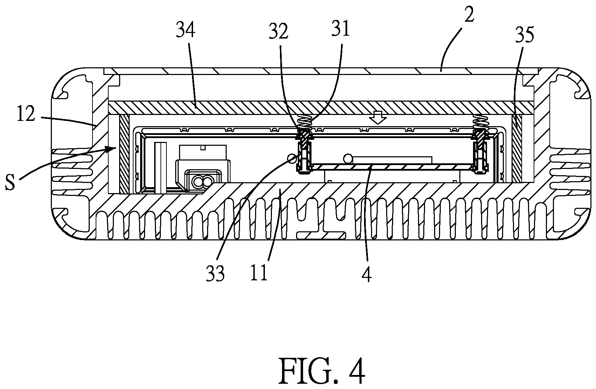

For another example, as shown in FIG. 4, in the third embodiment of the present invention, the pre-pressure plate 34 is connected to the bottom plate 11 through support columns 35. The height of the support column 35 determines the pre-pressure stroke of the pre-pressure plate 34. By adjusting the pre-pressure stroke of the pre-pressure plate 34, the pre-pressure exerted on the pressure-receiving piece 32 and the CPU holder 4 can be changed.

In other words, in the present invention, the CPU can form thermal contact with the box body 1 through the pre-pressure from the backplate 2 or the pre-pressure plate 34, and dissipate heat through the box body 1.

Further, in the present embodiment, as shown in FIGS. 1-2, the pre-pressure assembly 3 includes a plurality of pushing pieces 31 and a plurality of pressure-receiving pieces 32, and the plurality of pressure-receiving pieces 32 surround the CPU holder 4.

Further, in the present embodiment, the pre-pressure assembly 3 further includes a screw 33 to fixedly connect the pressure-receiving piece 32 and the motherboard P, so that the motherboard P is locked to the CPU holder 4. The screw 33 also has the effect of positioning the pushing piece 31.

Further, in the present embodiment, an outer surface of the box body 1 is provided with a plurality of heat dissipation fins 13 to increase the surface area and further promote heat dissipation.

Further, in the present embodiment, the computer chassis structure 100 and the motherboard P can be combined to form the computer host 200, wherein the pushing piece 31 passes through the motherboard P and pushes the pressure-receiving piece 32.

While the present invention has been described by means of embodiments, those skilled in the art should understand the above description is merely embodiments of the invention, and it should not be considered to limit the scope of the invention. It should be noted that all changes and substitutions which come within the meaning and range of equivalency of the embodiments are intended to be embraced in the scope of the invention. Therefore, the scope of the invention is defined by the claims.

## Claims

1. A computer chassis structure (100), comprising:
a box body (1) including a bottom plate (11) and a plurality of side walls (12) surrounding the bottom plate (11);
a backplate (2), having an outer face (21) and an inner face (22) opposite to the outer face (21), wherein the inner face (22) is disposed towards the bottom plate (11), and the backplate(2), the bottom plate (11) and the plurality of side walls (12) are sandwiched to form an accommodation space (S);
a pre-pressure assembly (3), disposed in the accommodation space (S),
wherein the pre-pressure assembly (3) includes a pushing piece (31) and a pressure-receiving piece (32), the pressure-receiving piece (32) is disposed at the bottom plate (11), and the pushing piece (31) pushes an adjustable pre-pressure toward the pressure-receiving piece (32) along a covering direction of the backplate (2); and
a CPU holder (4), fixedly connected to the pressure-receiving piece (32).

2. The computer chassis structure (100) according to claim 1, wherein one end of the pushing piece (31) is connected to the inner face (22) to push the adjustable pre-pressure toward the pressure-receiving piece (32).

3. The computer chassis structure (100) according to claim 1, wherein one end of the pushing piece (31) is indirectly connected to the box body (1) to push the adjustable pre-pressure toward the pressure-receiving piece (32).

4. The computer chassis structure (100) according to claim 3, wherein the pre-pressure assembly (3) further includes a pre-pressure plate (34), which is disposed in the accommodation space (S), and one end of the pushing piece (31) is indirectly connected to the box body (1) through the pre-pressure plate (34).

5. The computer chassis structure (100) according to claim 4, wherein the pre-pressure plate (34) is connected to at least two of the plurality of side walls (12).

6. The computer chassis structure (100) according to claim 4, wherein the pre-pressure plate (34) is connected to the bottom plate (11).

7. The computer chassis structure (100) according to claim 1, wherein the pre-pressure assembly (3) includes a plurality of pushing pieces (31) and a plurality of pressure-receiving pieces (32), and the plurality of pressure-receiving pieces (32) surround the CPU holder (4).

8. The computer chassis structure (100) according to claim 1, wherein the pre-pressure assembly (3) further includes a screw (33) to fixedly connect the pressure-receiving piece (32) and a motherboard (P).

9. The computer chassis structure (100) according to claim 1, wherein an outer surface of the box body (1) is provided with a plurality of heat dissipation fins (13).

10. A computer host (200), comprising:
a motherboard (P); and
the computer chassis structure (100) according to claim 1, wherein the pushing piece (31) passes through the motherboard (P) and pushes the pressure-receiving piece (32).
